# EUROPEAN PATENT SPECIFICATION

(11) **EP 4 223 852 B1**
(45) Date of publication and mention of the grant of the patent: **06.11.2024**
(21) Application number: 23154509.6
(22) Date of filing: 01.02.2023
(51) Int. Cl.: C09K 11/02, C09K 11/56, C09K 11/70, C09K 11/88

(54) **QUANTUM DOT, METHOD OF PREPARING THE QUANTUM DOT, AND ELECTRONIC APPARATUS INCLUDING THE QUANTUM DOT**
QUANTENPUNKT, VERFAHREN ZUR HERSTELLUNG DES QUANTENPUNKTS UND ELEKTRONISCHE VORRICHTUNG MIT DEM QUANTENPUNKT
POINT QUANTIQUE, PROCÉDÉ DE PRÉPARATION DU POINT QUANTIQUE, ET APPAREIL ÉLECTRONIQUE COMPRENANT LE POINT QUANTIQUE

(30) Priority: 03.02.2022 KR 20220014474; 22.08.2022 KR 20220104911
(43) Date of publication of application: 09.08.2023
(73) Proprietor: Samsung Display Co., Ltd., Yongin-si, Gyeonggi-do 17113 (KR)
(72) Inventor: Jung, Yunku, 17113 Yongin-si, Gyeonggi-do (KR); Ko, Yunhyuk, 17113 Yongin-si, Gyeonggi-do (KR); Park, Chulsoon, 17113 Yongin-si, Gyeonggi-do (KR); Suh, Yohan, 17113 Yongin-si, Gyeonggi-do (KR); Lee, Sooho, 17113 Yongin-si, Gyeonggi-do (KR); Han, Changyeol, 17113 Yongin-si, Gyeonggi-do (KR)
(74) Representative: Gulde & Partner

(56) References cited:
- EP-A1- 3 819 354
- US-A1- 2013 092 883
- US-A1- 2021 246 370
- US-A1- 2021 301 202

## Description

### BACKGROUND

### 1. Field

The present disclosure relates to a quantum dot, a method of preparing the quantum dot, and an electronic apparatus including the quantum dot.

### 2. Description of the Related Art

Quantum dots may be utilized as materials that perform one or more suitable optical functions (for example, a light conversion function, a light emission function, and/or the like) in optical members and various suitable electronic apparatuses. Quantum dots, which are semiconductor nanocrystals with a quantum confinement effect, may have different energy bandgaps according to the size and composition of the nanocrystals, and accordingly may emit light of various suitable emission wavelengths.

An optical member including such quantum dots may have the form of a thin film, for example, a thin film patterned for each subpixel. Such an optical member may be utilized as a color conversion member of a device including various suitable light sources.

The quantum dots may be utilized for a variety of purposes in various suitable electronic apparatuses. For example, the quantum dots may be utilized as emitters (e.g., light emitters). For example, the quantum dots may be included in an emission layer of a light-emitting device including a pair of electrodes and the emission layer, and may serve as an emitter. Examples may be found in EP 3819354 A1, US 2021/301202 A1, US 2021/246370 A1 or US 2013/0092883 A1.

Currently, to implement high-definition optical members and electronic apparatuses, there is a need for the development of quantum dots that emit blue light having a maximum emission wavelength (e.g., peak emission wavelength) of less than or equal to 490 nm and do not include cadmium, which may be consider toxic.

### SUMMARY

The invention is defined by the appended claims. Aspects according to one or more embodiments are directed toward a novel quantum dot, a method of preparing the same, and an electronic apparatus including the same.

Additional aspects will be set forth in part in the description which follows and, in part, will be apparent from the description, or may be learned by practice of the presented embodiments of the disclosure.

### BRIEF DESCRIPTION OF THE DRAWINGS

Aspects, features, and enhancements of certain embodiments of the disclosure will be more apparent from the following description taken in conjunction with the accompanying drawings, in which:
FIG. 1 is a schematic cross-sectional view of a quantum dot according to an embodiment;
FIG. 2 is a diagram schematically illustrating a method of preparing a quantum dot according to an embodiment;
FIG. 3 is a schematic view showing a structure of an electronic apparatus according to an embodiment;
FIG. 4 is a schematic view of an electronic apparatus according to another embodiment; and
FIG. 5 is a diagram showing emission wavelengths of quantum dots according to Example 1 and Comparative Example 1.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described below, by referring to the drawings, to explain aspects of the present description. As used herein, the term "and/or" includes any and all combinations of one or more of the associated listed items. Throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

The terminology used herein is for the purpose of describing particular embodiments only and is not intended to be limiting of the inventive concept. As used herein, the singular forms "a", "an" and "the" (e.g., a quantum dot, the quantum dot, an element, the element, etc.,) are intended to include the plural forms as well, unless the context clearly indicates otherwise.

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

It will be understood that although the terms "first," "second," etc. used herein may be used herein to describe various components, these components should not be limited by these terms. These terms are only used to distinguish one component from another.

An expression used in the singular encompasses the expression of the plural, unless it has a clearly different meaning in the context.

In the present specification, it is to be understood that the terms such as "including," "having," and "comprising" are intended to indicate the presence of the features or components disclosed in the specification, and are not intended to preclude the possibility that one or more other features or components may exist or may be added. For example, unless otherwise limited, terms such as "including" or "having" may refer to either consisting of features or components described in the specification only or further including other components.

The term "Group II" as used herein may include a Group IIA element and a Group IIB element on the IUPAC periodic table, and the Group II element may include, for example, magnesium (Mg), calcium (Ca), zinc (Zn), cadmium (Cd), mercury (Hg), and/or the like.

The term "Group III" as used herein may include a Group IIIA element and a Group IIIB element on the IUPAC periodic table, and the Group III element may include, for example, aluminum (Al), gallium (Ga), indium (In), thallium (Tl), and/or the like.

The term "Group V" as used herein may include a Group VA element and a Group VB element on the IUPAC periodic table, and the Group V element may include, for example, nitrogen (N), phosphorus (P), arsenic (As), antimony (Sb), and/or the like.

The term "Group VI" as used herein may include a Group VIA element and a Group VIB element on the IUPAC periodic table, and the Group VI element may include, for example, sulfur (S), selenium (Se), tellurium (Te), and/or the like.

### Quantum dot

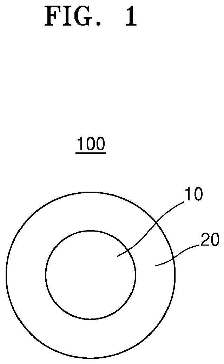

FIG. 1 is a schematic cross-sectional view of a quantum dot according to an embodiment.

A quantum dot 100 according to embodiment includes: a core 10; and a shell 20 around (e.g., covering) at least a portion of the core 10, wherein the core 10 includes a first semiconductor compound including or consisting of indium (In) and phosphorus (P).

In the first semiconductor compound, the number of moles (mol) of In relative to the number of moles (mol) of P (M^{In}/M^{P}) is greater than 1. That is, in the first semiconductor compound, a ratio between the number of moles (mol) of In and the number of moles (mol) of P (M^{In}/M^{P}) is greater than 1 (e.g., greater than 1:1). In other words, in the first semiconductor compound, the number of moles (mol) of In is greater than the number of moles (mol) of P. Here, M^{In} indicates the number of moles of In included in the first semiconductor compound, and M^{P} indicates the number of moles of P included in the first semiconductor compound.

In an embodiment, the first semiconductor compound may not include (e.g., may exclude) any metal or metalloid other than In.

For example, the first semiconductor compound may not include (e.g., may exclude) any metal or metalloid other than In, such as Ga, Al, Sb, As, Bi, and/or the like.

For example, the first semiconductor compound may consist of InP.

In an embodiment, the core 10 may optionally include a second semiconductor compound including a first element and P.

The binding energy between the first element and P may be greater than the binding energy between In and P. For example, the first element may be an element having a greater binding energy with P than In does.

In an embodiment, the first element may include Ga, Al, Sb, As, Bi, or any combination thereof.

In an embodiment, the second semiconductor compound may be a compound in which the first element and P are combined.

For example, the second semiconductor compound may include GaP, AIP, SbP, As₃P, BiP, or any combination thereof.

In an embodiment, the shell 20 may include an oxide of a metal, a metalloid, and/or a non-metal, a third semiconductor compound, or a combination thereof.

Examples of the oxide of a metal, a metalloid, and/or a non-metal may include (e.g., may be): a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; a ternary compound, such as MgAl₂O₄, CoFe₂O₄, NiFe₂O₄, CoMn₂O₄, and/or the like; or any combination thereof.

Examples of the third semiconductor compound may include (e.g., may be): a Group II-VI semiconductor compound; a Group III-V semiconductor compound; a Group III-VI semiconductor compound; a Group I-III-VI semiconductor compound; a Group IV-VI semiconductor compound; or any combination thereof.

Examples of the Group II-VI semiconductor compound may include (e.g., may be): a binary compound, such as CdS, CdSe, CdTe, ZnS, ZnSe, ZnTe, ZnO, HgS, HgSe, HgTe, MgSe, MgS, and/or the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or any combination thereof.

Examples of the Group III-V semiconductor compound may include (e.g., may be): a binary compound, such as GaN, GaP, GaAs, GaSb, AIN, AIP, AlAs, AlSb, InN, InP, InAs, InSb, and/or the like; a ternary compound, such as GaNP, GaNAs, GaNSb, GaPAs, GaPSb, AINP, AINAs, AINSb, AIPAs, AlPSb, InGaP, InNP, InAlP, InNAs, InNSb, InPAs, InPSb, and/or the like; a quaternary compound, such as GaAINP, GaAINAs, GaAINSb, GaAIPAs, GaAIPSb, GalnNP, GalnNAs, GaInNSb, GalnPAs, GalnPSb, InAINP, InAINAs, InAINSb, InAIPAs, InAIPSb, and/or the like; or any combination thereof. In an embodiment, the Group III-V semiconductor compound may further include a Group II element. Examples of the Group III-V semiconductor compound further including the Group II element may include (e.g., may be) InZnP, InGaZnP, InAIZnP, and/or the like.

Examples of the Group III-VI semiconductor compound may include (e.g., may be): a binary compound, such as GaS, GaSe, Ga₂Se₃, GaTe, InS, InSe, In₂S₃, In₂Se₃, InTe, and/or the like; a ternary compound, such as InGaS₃, InGaSe₃, and/or the like; or any combination thereof.

Examples of the Group I-III-VI semiconductor compound may include (e.g., may be): a ternary compound, such as AgInS, AgInS₂, CulnS, CuInS₂, CuGaO₂, AgGaO₂, AgAlO₂, and/or the like; or any combination thereof.

Examples of the Group IV-VI semiconductor compound may include (e.g., may be): a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or any combination thereof.

Examples of the third semiconductor compound may include (e.g., may be) ZnS, ZnSe, ZnTe, ZnO, ZnSeS, ZnTeS, GaAs, GaP, GaN, GaO, GaSb, HgS, HgSe, HgTe, InAs, InP, InS, InGaP, InSb, InZnP, InZnS, InGaP, InGaN, AlAs, AIP, AlSb, PbS, TiO, SrSe, or any combination thereof.

Each element included in a multi-element compound, such as the binary compound, the ternary compound, and/or the quaternary compound, may be present at a substantially uniform concentration or non-uniform (e.g., substantially non-uniform) concentration in a particle.

In an embodiment, the shell 20 may include ZnS, ZnSe, ZnTe, ZnO, ZnSeS, ZnTeS, GaAs, GaP, GaN, GaO, GaSb, HgS, HgSe, HgTe, InAs, InP, InS, InGaP, InSb, InZnP, InZnS, InGaP, InGaN, AlAs, AIP, AlSb, PbS, TiO, SrSe, or any combination thereof.

The shell 20 of the quantum dot 100 may act (e.g., serve) as a protective layer which prevents or reduces chemical denaturation of the core 10 to maintain semiconductor characteristics, and/or as a charging layer which impart electrophoretic characteristics to the quantum dot 100. The shell 20 may have a single layer or a multi-layer structure. The interface between the core 10 and the shell 20 may have a concentration gradient in which the concentration of an element existing in the shell 20 decreases toward the center of the core 10.

In an embodiment, a full width at half maximum (FWHM) of an emission wavelength spectrum of the quantum dot 100 may be about 45 nm or less, for example, about 40 nm or less, or, about 30 nm or less, and within these ranges, color purity and/or color reproducibility may be increased. In some embodiments, because light emitted through the quantum dot 100 is emitted in all directions, the wide viewing angle may be improved.

In some embodiments, the quantum dot 100 may be in the form of spherical, pyramidal, multi-arm, or cubic nanoparticles, nanotubes, nanowires, nanofibers, and/or nanoplate particles.

In an embodiment, the quantum dot 100 may be to emit blue light.

Further, a maximum (e.g., peak) emission wavelength of the quantum dot 100 is in a range of about 430 nm to about 470 nm.

### Preparation method of quantum dot

A method of preparing a quantum dot according to an embodiment includes: preparing a precursor 11A of a first semiconductor compound including or consisting of In and P; preparing a mixture including the precursor 11A of the first semiconductor compound and a surface-etching material; and preparing a first semiconductor compound 11 utilizing the mixture. In the first semiconductor compound, the number of moles (mol) of In relative to the number of moles (mol) of P (M^{In}/M^{P}) may be greater than 1. That is, in the first semiconductor compound, a ratio between the number of moles (mol) of In and the number of moles (mol) of P (M^{In}/M^{P}) may be greater than 1 (e.g., greater than 1:1).

In an embodiment, the first semiconductor compound may not include (e.g., may exclude) any metal or metalloid other than In.

For example, the first semiconductor compound may not include (e.g., may exclude) any metal or metalloid other than In, such as Ga, Al, Sb, As, Bi, and/or the like.

The surface-etching material includes a first element.

As described above, the binding energy between the first element and P greater than the binding energy between In and P. For example, the first element may be an element having a greater binding energy with P than In does.

In an embodiment, the first element may include Ga, Al, Sb, As, Bi, or any combination thereof.

In an embodiment, the surface-etching material may include a second element.

In an embodiment, the second element may include a halogen element. For example, the second element may be F or Cl.

In an embodiment, the surface-etching material may include GaF₃, AlF₃, SbF₃, AsF, BiF₃, GaCl₃, AlCl₃, SbCl₃, AsCI, BiCl₃, or any combination thereof.

In an embodiment, the surface-etching material may include the first element and the second element, whereas the first semiconductor compound may not include (e.g., may exclude) the first element and the second element. The first element and the second element may each be the same as respectively described herein.

In an embodiment, the method of preparing the quantum dot may further include preparing a second semiconductor compound 12 utilizing the mixture.

The preparing of the second semiconductor compound 12 may be performed sequentially or concurrently (e.g., simultaneously) with the preparing of the first semiconductor compound 11.

The second semiconductor compound 12 may include a first element and P, and the first element may be the same as described herein.

In an embodiment, the second semiconductor compound may include GaP, AIP, SbP, As₃P, BiP, or any combination thereof.

In an embodiment, the preparing of the first semiconductor compound may include heating the mixture.

The method of preparing the quantum dot includes: preparing a core 10 including the first semiconductor compound 11; and a shell 20 around (e.g., covering) at least a portion of the core 10.

The preparing of the core 10 may include: preparing the precursor 11A of the first semiconductor compound including In and P; preparing the mixture including the precursor 11A of the first semiconductor compound and a surface-etching material; and preparing the first semiconductor compound 11 utilizing the mixture.

In an embodiment, the preparing of the core 10 may further include preparing a second semiconductor compound 12 utilizing the mixture, wherein the second semiconductor compound may include a first element and P. The first element may be the same as described herein.

In an embodiment, the core 10 may optionally include the second semiconductor compound 12 including the first element and P.

In an embodiment, the shell 20 may include an oxide of a metal, a metalloid, and/or a non-metal, a third semiconductor compound, or a combination thereof.

Examples of the oxide of a metal, a metalloid, and/or a non-metal may include (e.g., may be): a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or the like; a ternary compound, such as MgAl₂O₄, CoFe₂O₄, NiFe₂O₄, CoMn₂O₄, and/or the like; or any combination thereof.

Examples of the third semiconductor compound may include (e.g., may be): a Group II-VI semiconductor compound; a Group III-V semiconductor compound; a Group III-VI semiconductor compound; a Group I-III-VI semiconductor compound; a Group IV-VI semiconductor compound; or any combination thereof.

For example, the shell 20 may include ZnS, ZnSe, ZnTe, ZnO, ZnSeS, ZnTeS, GaAs, GaP, GaN, GaO, GaSb, HgS, HgSe, HgTe, InAs, InP, InS, InGaP, InSb, InZnP, InZnS, InGaP, InGaN, AlAs, AIP, AlSb, PbS, TiO, SrSe, or any combination thereof.

In an embodiment, the quantum dot prepared by the method of preparing the quantum dot may have a maximum (e.g., peak) emission wavelength in a range of about 430 nm to about 470 nm.

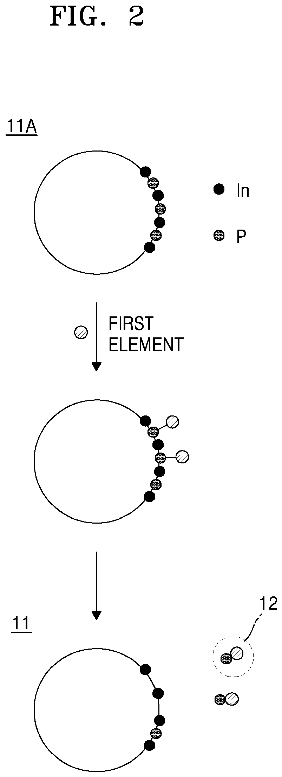

FIG. 2 is a diagram schematically illustrating the preparation method of the quantum dot according to an embodiment.

When the surface-etching material including the first element is added to a solution containing the precursor 11A of the first semiconductor compound 11 including In and P, a bond between In and P on the surface of the precursor 11A of the first semiconductor compound may be broken down by the first element, and the first element and P may then be combined to generate the second semiconductor compound 12. Thus, the binding energy is understood as bond-dissociation energy in this disclosure.

Accordingly, the quantum dot 100 including, as the core 10, the first semiconductor compound 11 having the etched surface through the reaction above, may have a reduced effective core size so that an emission wavelength is shifted toward a shorter wavelength region. Therefore, by the method of preparing the quantum dot according to the present disclosure, a quantum dot that effectively has a shorter emission wavelength (for example, between 430 nm and 470 nm) may be provided.

### Optical member

The quantum dot may be utilized in one or more suitable optical members. Accordingly, an optical member including the quantum dot may be provided.

In an embodiment, the optical member may be a light control means (e.g., light control member).

In one or more embodiments, the optical member may be a color filter, a color conversion member, a capping layer, a light-extraction efficiency enhancement layer, a selective light-absorption layer, and/or a polarizing layer.

### Electronic apparatus

The quantum dot may be utilized in one or more suitable electronic apparatuses. Accordingly, an electronic apparatus including the quantum dot may be provided.

In an embodiment, an electronic apparatus may include: a light source; and a color conversion member arranged in an optical path of light emitted from the light source, wherein the color conversion member includes the quantum dot.

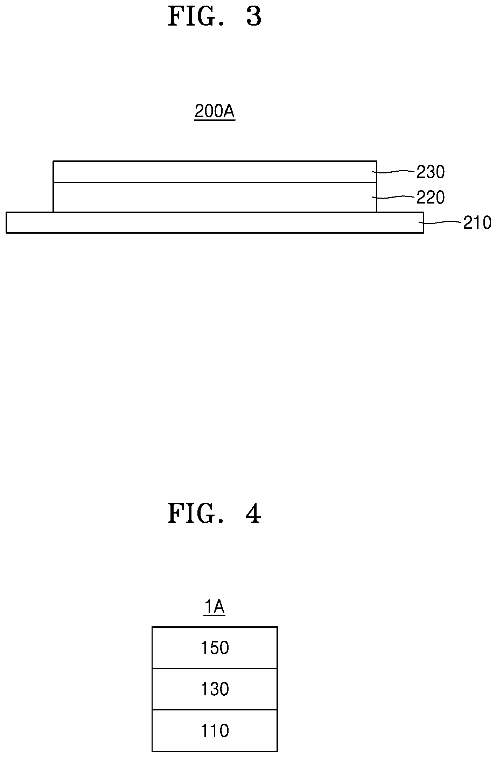

FIG. 3 is a schematic view showing a structure of an electronic apparatus 200A according to an embodiment. The electronic apparatus 200A of FIG. 3 includes: a substrate 210; a light source 220 arranged on the substrate 210; and a color conversion member 230 arranged on the light source 220.

For example, the light source 220 may be a backlight unit (BLU) for usage in liquid crystal displays (LCD), a fluorescent lamp, a light-emitting device, an organic light-emitting device, a quantum-dot light-emitting device (QLED), or any combination thereof. The color conversion member 230 may be arranged in at least one direction of travel of light emitted from the light source 220.

At least a region of the color conversion member 230 of the electronic apparatus 200A includes the quantum dot, and that region absorbs light emitted from the light source 220 to emit blue light having a maximum emission wavelength in a range of about 400 nm to about 490 nm.

Here, a case where the color conversion member 230 is arranged in at least one direction of travel of the light emitted from the light source 220 does not exclude other elements from being further included between the color conversion member 230 and the light source 220.

In an embodiment, between the light source 220 and the color conversion member 230, a polarizing plate, a liquid crystal layer, a light guide plate, a diffusion plate, a prism sheet, a microlens sheet, a luminance enhancing sheet, a reflective film, a color filter, or any combination thereof may be additionally arranged (e.g., included).

In one or more embodiments, a polarizing plate, a liquid crystal layer, a light guide plate, a diffusion plate, a prism sheet, a microlens sheet, a luminance enhancing sheet, a reflective film, a color filter, or any combination thereof may be additionally arranged on the color conversion member 230.

The electronic apparatus 200A of FIG. 3, which is an embodiment according to the disclosure, may have any of various suitable shapes, and accordingly, may further include various suitable structures.

In one or more embodiments, the electronic apparatus may include a structure including a light source, a light guide plate, a color conversion member, a first polarizing plate, a liquid crystal layer, a color filter, and a second polarizing plate that are sequentially arranged in the stated order.

In one or more embodiments, the electronic apparatus may include a structure including a light source, a light guide plate, a first polarizing plate, a liquid crystal layer, a second polarizing plate, and a color conversion member that are sequentially arranged in the stated order.

In the embodiments described above, the color filter may include a pigment and/or a dye. In the embodiments described above, one selected from among the first polarizing plate and the second polarizing plate may be a vertical polarizing plate, and the other one may be a horizontal polarizing plate.

Here, the quantum dot as described herein may be utilized as an emitter (e.g., light emitter). Accordingly, in one or more embodiments, an electronic apparatus including a light-emitting device that includes: a first electrode; a second electrode facing the first electrode; and an emission layer arranged between the first electrode and the second electrode may be provided, wherein the light-emitting device (for example, the emission layer of the light-emitting device) includes the quantum dot. The light-emitting device may further include a hole transport region arranged between the first electrode and the emission layer, an electron transport region arranged between the emission layer and the second electrode, or a combination thereof.

### Description of FIG. 4

FIG. 4 is a schematic cross-sectional view of a light-emitting device 1A according to an embodiment of the present disclosure. The light-emitting device 1A includes a first electrode 110, an interlayer 130, and a second electrode 150.

Hereinafter, the structure of the light-emitting device 1A according to an embodiment and a method of manufacturing the light-emitting device 1A will be described with reference to FIG. 4.

### First electrode 110

A substrate may be additionally arranged under the first electrode 110 and/or on the second electrode 150 of FIG. 4. In an embodiment, as the substrate, a glass substrate and/or a plastic substrate may be utilized. In one or more embodiments, the substrate may be a flexible substrate, and for example, may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In an embodiment, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 is arranged on the first electrode 110. The interlayer 130 may include an emission layer.

The interlayer 130 may further include a hole transport region arranged between the first electrode 110 and the emission layer, and an electron transport region arranged between the emission layer and the second electrode 150.

In an embodiment, the interlayer 130 may further include, in addition to one or more suitable organic materials, a metal-containing compound such as an organometallic compound, an inorganic material such as quantum dot(s), and/or the like.

In one or more embodiments, the interlayer 130 may include, i) two or more emitting units sequentially stacked between the first electrode 110 and the second electrode 150, and ii) a charge generation layer between the two or more emitting units. When the interlayer 130 includes the two or more emitting units and the charge generation layer, the light-emitting device 1A may be a tandem light-emitting device.

### Hole transport region in interlayer 130

The hole transport region may have: i) a single-layered structure consisting of a single layer consisting of a single material, ii) a single-layered structure consisting of a single layer including (e.g., consisting of) a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110 in the respective stated order.

The hole transport region may include a compound represented by Formula 201, a compound represented by Formula 202, or any combination thereof:

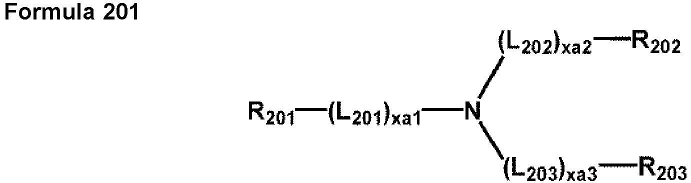

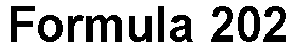

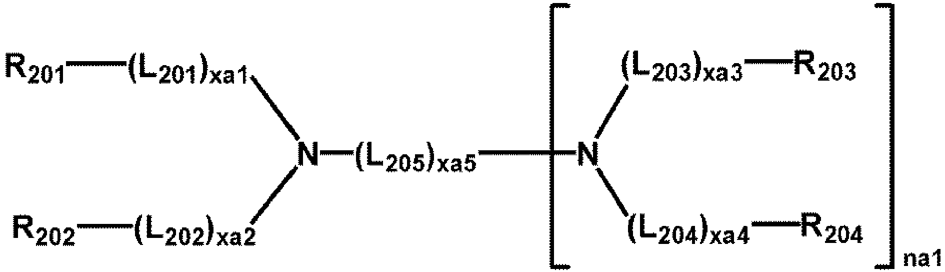

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R_{1Oa},
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R_{1Oa},
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R_{1Oa},
R₂₀₁ and R₂₀₂ may optionally be bonded to each other via a single bond, a C₁-C₅ alkylene group unsubstituted or substituted with at least one R_{1Oa}, or a C₂-C₆ alkenylene group unsubstituted or substituted with at least one R_{1Oa}, to form a C₈-C₆₀ polycyclic group (for example, a carbazole group, etc.) unsubstituted or substituted with at least one R₁₀ₐ (for example, Compound HT16, etc.),
R₂₀₃ and R₂₀₄ may optionally be bonded to each other via a single bond, a C₁-C₅ alkylene group unsubstituted or substituted with at least one R_{1Oa}, or a C₂-C₆ alkenylene group unsubstituted or substituted with at least one R_{1Oa}, to form a C₈-C₆₀ polycyclic group unsubstituted or substituted with at least one R_{1Oa}, and
na1 may be an integer from 1 to 4.

For example, each of Formulae 201 and 202 may include at least one of the groups represented by Formulae CY201 to CY217:

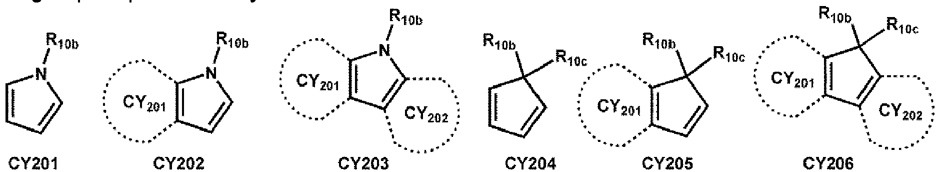

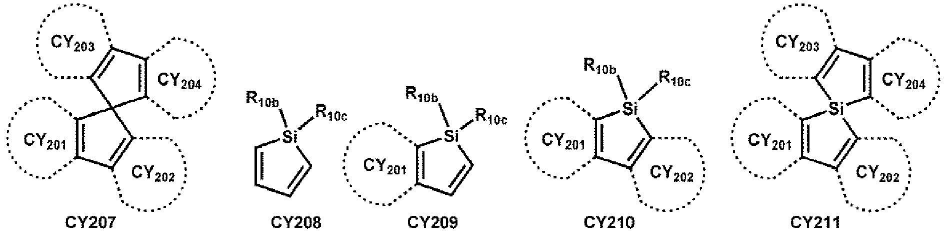

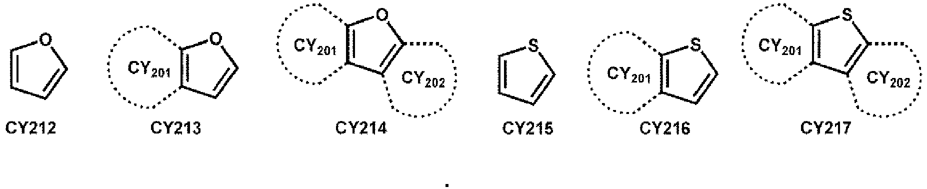

In Formulae CY201 to CY217, R_{10b} and R_{10c} may each be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described above.

In an embodiment, in Formulae CY201 to CY217, ring CY₂₀₁ to ring CY₂₀₄ may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not include (e.g., may exclude) any of the groups represented by Formulae CY201 to CY203.

In one or more embodiments, each of Formulae 201 and 202 may not include (e.g., may exclude) any of the groups represented by Formulae CY201 to CY203, and may include at least one of the groups represented by Formulae CY204 to CY217.

In one or more embodiments, each of Formulae 201 and 202 may not include (e.g., may exclude) any of the groups represented by Formulae CY201 to CY217.

For example, the hole transport region may include at least one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

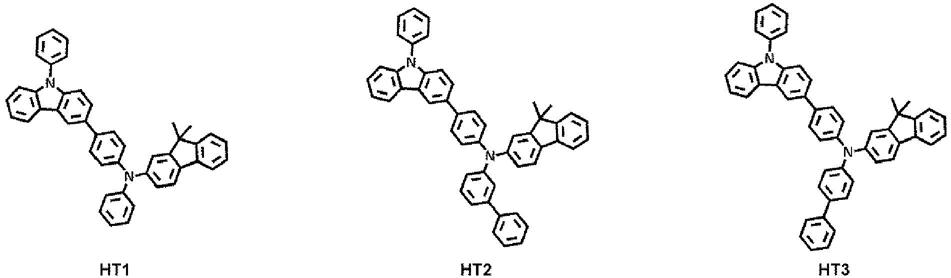

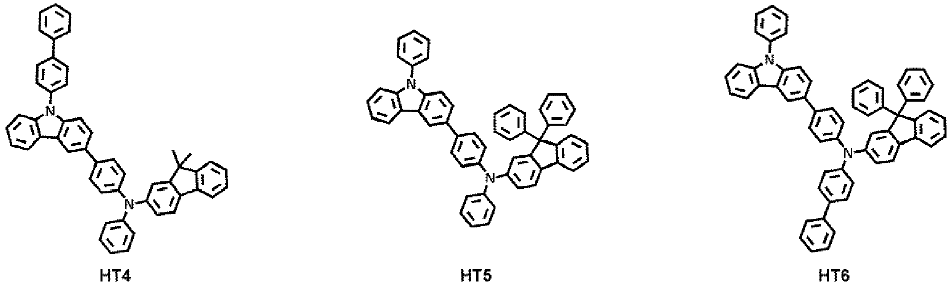

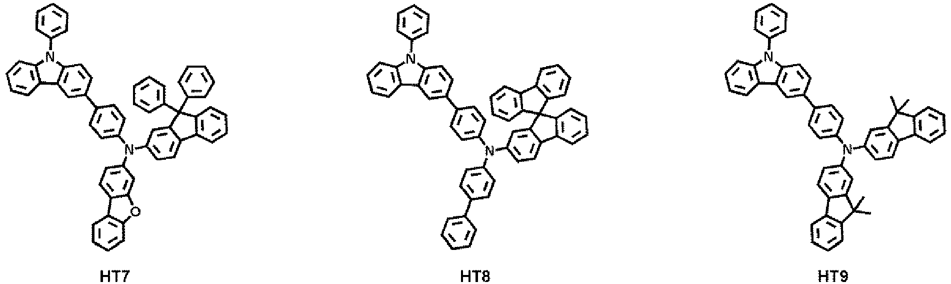

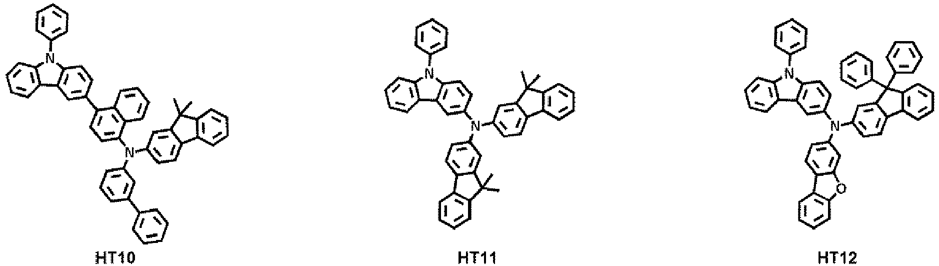

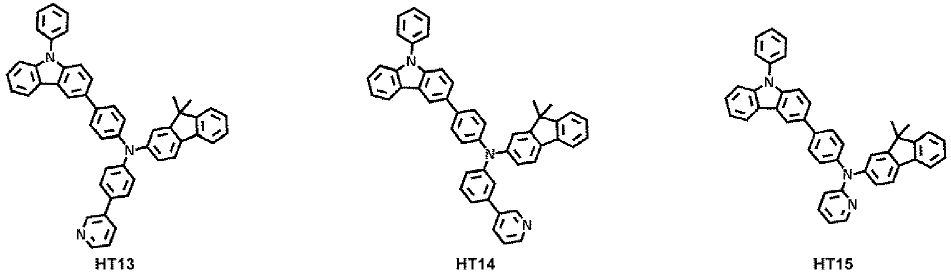

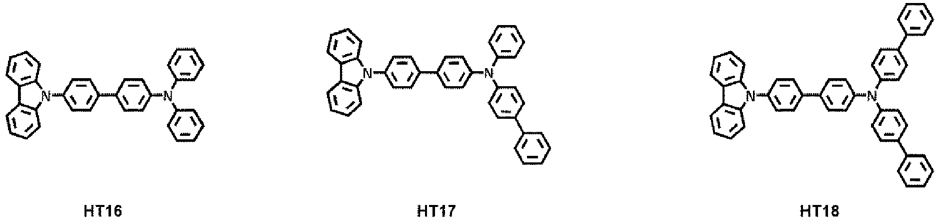

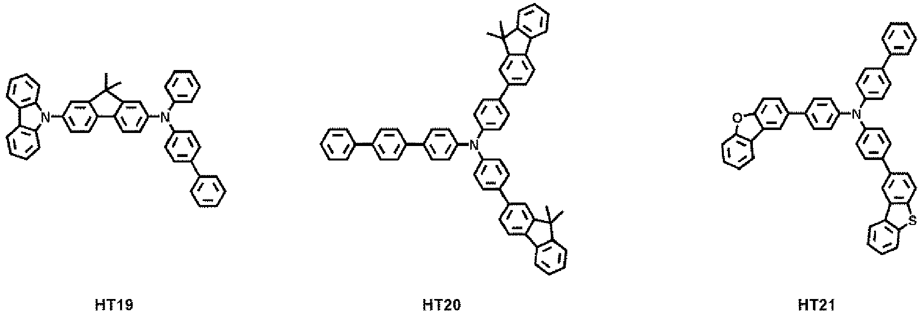

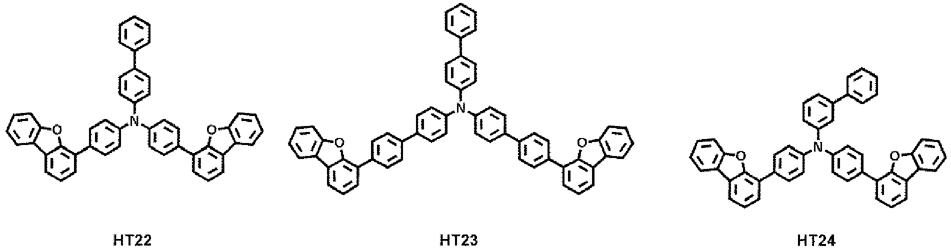

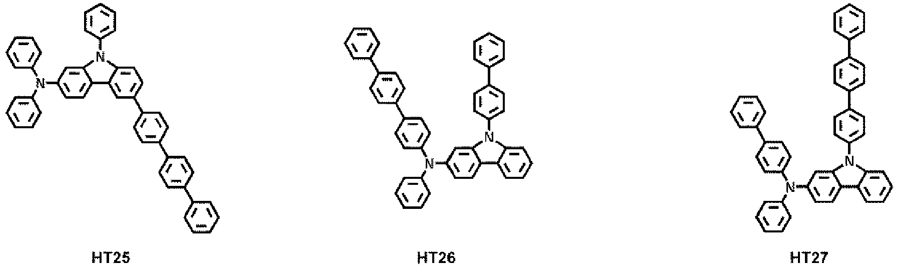

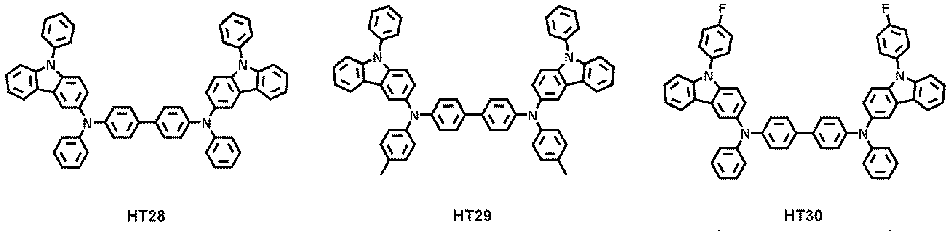

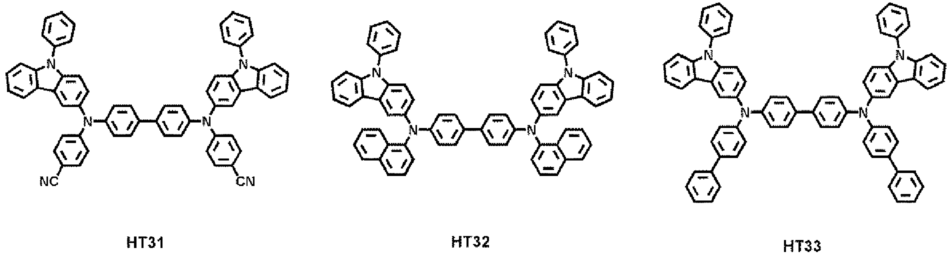

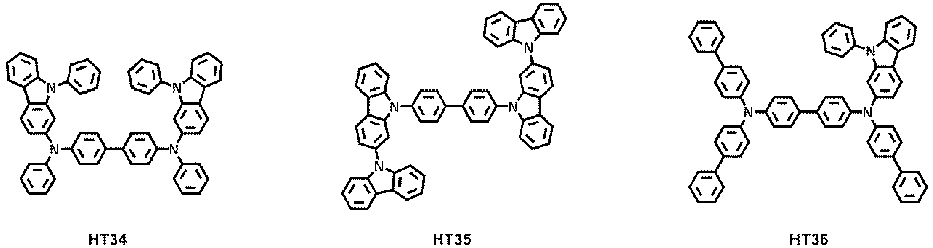

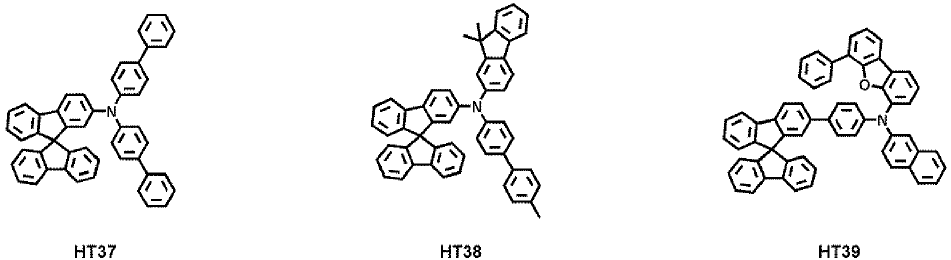

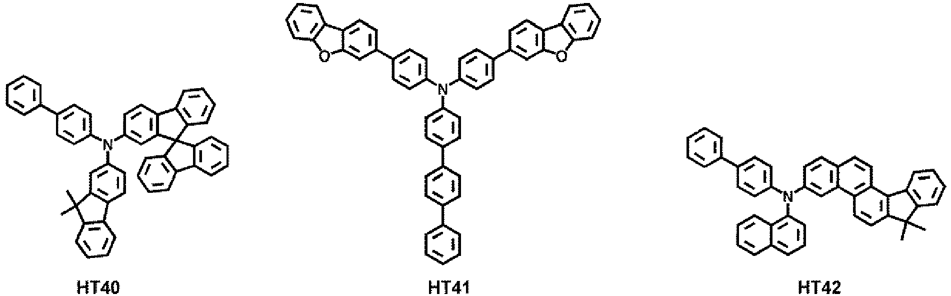

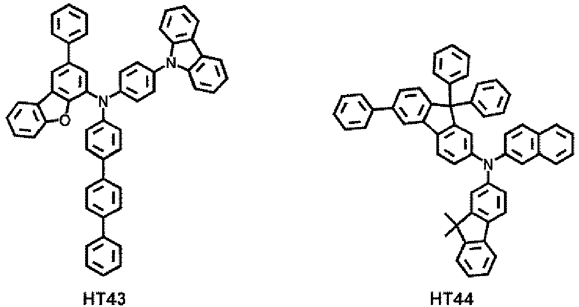

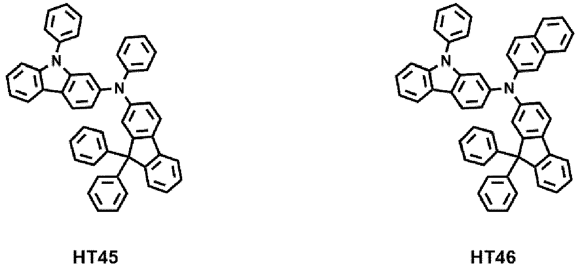

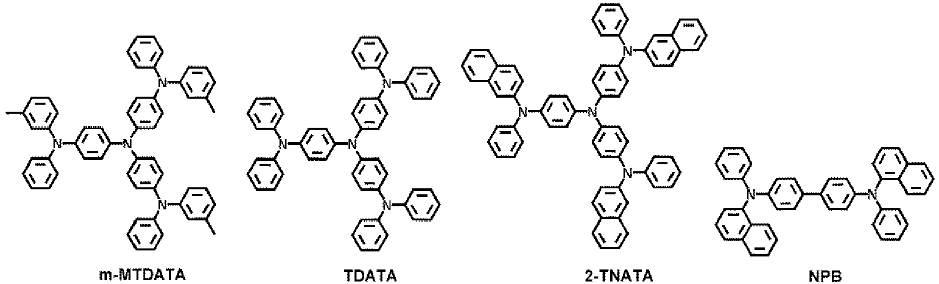

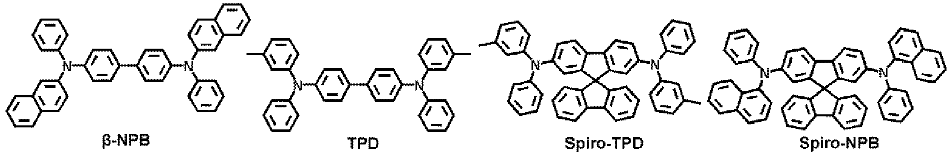

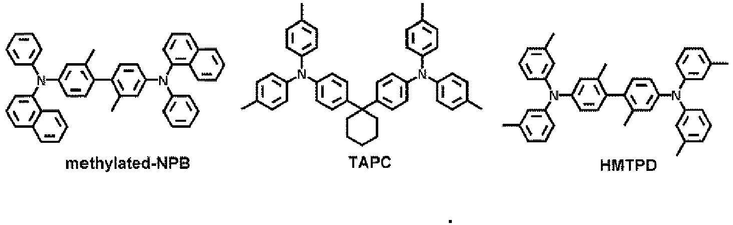

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron-blocking layer may block or reduce the leakage of electrons from the emission layer to the hole transport region. Materials that may be included in the hole transport region may be included in the emission auxiliary layer and the electron-blocking layer.

### p-dopant

The hole transport region may further include, in addition to these materials, a charge-generation material for the improvement of conductive properties. The charge-generation material may be uniformly or non-uniformly dispersed in the hole transport region (for example, in the form of a single layer including (e.g., consisting of) the charge-generation material).

The charge-generation material may be, for example, a p-dopant.

For example, the p-dopant may have a lowest unoccupied molecular orbital (LUMO) energy level of less than or equal to -3.5 eV.

In an embodiment, the p-dopant may include a quinone derivative, a cyano group-containing compound, a compound including element EL1 and element EL2 (to be described in more detail below), or any combination thereof.

Examples of the quinone derivative may include (e.g., may be) TCNQ, F4-TCNQ, and/or the like.

Examples of the cyano group-containing compound may include (e.g., may be) HAT-CN a compound represented by Formula 221, and/or the like:

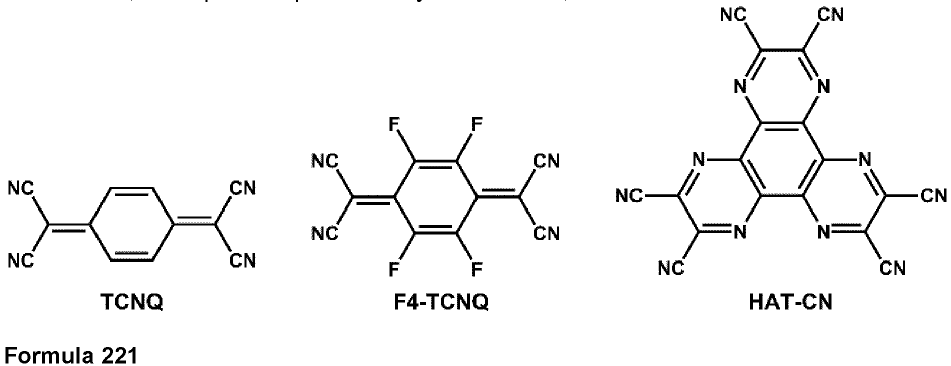

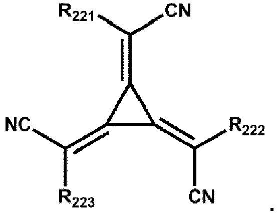

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; - Br; -I; a C₁-C₂₀ alkyl group substituted with a cyano group, -F, -Cl, -Br, -I, or any combination thereof; or any combination thereof.

In the compound including element EL1 and element EL2, element EL1 may be a metal, a metalloid, or any combination thereof, and element EL2 may be a non-metal, a metalloid, or any combination thereof.

Examples of the metal may include (e.g., may be) an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Examples of the metalloid may include (e.g., may be) silicon (Si), antimony (Sb), tellurium (Te), and/or the like.

Examples of the non-metal may include (e.g., may be) oxygen (O), halogen (for example, F, Cl, Br, I, etc.), and/or the like.

Examples of the compound including element EL1 and element EL2 may include (e.g., may be) a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, or any combination thereof.

Examples of the metal oxide may include (e.g., may be) tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₆, etc.), rhenium oxide (for example, ReOs, etc.), and/or the like.

Examples of the metal halide may include (e.g., may be) an alkali metal halide, an alkaline earth metal halide, a transition metal halide, a post-transition metal halide, a lanthanide metal halide, and/or the like.

Examples of the alkali metal halide may include (e.g., may be) LiF, NaF, KF, RbF, CsF, LiCI, NaCl, KCI, RbCI, CsCI, LiBr, NaBr, KBr, RbBr, CsBr, Lil, Nal, KI, Rbl, Csl, and/or the like.

Examples of the alkaline earth metal halide may include (e.g., may be) BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Examples of the transition metal halide may include (e.g., may be) titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCl₃, NbBr₃, NbI₃, etc.), tantalum halide (for example, TaF₃, TaCl₃, TaBr₃, TaI₃, etc.), chromium halide (for example, CrF₃, CrCl₃, CrBr₃, CrI3, etc.), molybdenum halide (for example, MoF₃, MoCl₃, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, Col₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NH₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCI, CuBr, Cu!, etc.), silver halide (for example, AgF, AgCl, AgBr, Agl, etc.), gold halide (for example, AuF, AuCI, AuBr, Aul, etc.), and/or the like.

Examples of the post-transition metal halide may include (e.g., may be) zinc halide (for example, ZnF₂, ZnCl₂, ZnBr₂, ZnI₂, etc.), indium halide (for example, InI₃, etc.), tin halide (for example, SnI₂, etc.), and/or the like.

Examples of the lanthanide metal halide may include (e.g., may be) YbF, YbF₂, YbF₃, SmF₃, YbCl, YbCl₂, YbCl₃ SmCl₃, YbBr, YbBr₂, YbBr₃ SmBr₃, YbI, YbI₂, YbI₃, SmI₃, and/or the like.

Examples of the metalloid halide may include (e.g., may be) antimony halide (for example, SbCl₅, etc.) and/or the like.

Examples of the metal telluride may include (e.g., may be) an alkali metal telluride (for example, Li₂Te, a Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), a lanthanide metal telluride (for example, LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

The emission layer may be a quantum-dot single layer or have a structure in which two or more quantum-dot layers are stacked. For example, the emission layer 150 may be a quantum-dot (e.g., quantum-dot containing) single layer or may have a structure in which 2 to 100 quantum-dot layers are stacked.

The emission layer may include the quantum dot as described herein.

In addition to the quantum dot as described herein, the emission layer may further include different quantum dot(s) (e.g., quantum dots different from the quantum dot according to embodiments described above).

The emission layer may further include, in addition to the quantum dot as described herein, a dispersion medium in which the quantum dots are dispersed in a naturally coordinated form. The dispersion medium may be any suitable transparent medium that does not affect the optical performance of the quantum dot, is not deteriorated by light, does not reflect light, and/or does not absorb light. The dispersion medium may include an organic solvent, a polymer resin, or any combination thereof. For example, the organic solvent may include toluene, chloroform, ethanol, octane, or any combination thereof, and the polymer resin may include epoxy resin, silicone resin, polystyrene resin, acrylate resin, or any combination thereof.

The emission layer may be formed by coating the hole transport region with a quantum dot-containing composition for forming the emission layer and by volatilizing (e.g., evaporating) at least a portion of the solvent from the composition for forming the emission layer.

For example, as the solvent, water, hexane, chloroform, toluene, octane, and/or the like may be utilized.

The coating of the composition for forming the emission layer may be performed utilizing a spin coat method, a casting method, a micro gravure coating method, a gravure coating method, a bar coating method, a roll coating method, a wire bar coating method, a dip coating method, a spray coating method, a screen printing method, a flexographic method, an offset printing method, an ink jet printing method, and/or the like.

When the light-emitting device 1A is a full-color light-emitting device, the emission layer may include emission layers that emit light of different colors according to individual subpixels.

In an embodiment, the emission layer may be patterned into a first-color emission layer, a second-color emission layer, and a third-color emission layer according to individual subpixels. Here, at least one emission layer from among these emission layers may include the quantum dot. For example, the first-color emission layer may be a quantum dot-emission layer including the quantum dot, and the second-color emission layer and the third-color emission layer may be organic emission layers including organic compounds, respectively. Here, the first color through the third color may be colors different from each other, and for example, the first color through the third color may have different maximum (e.g., peak) emission wavelengths. The first color through the third color may be combined with each other to provide white color.

In one or more embodiments, the emission layer may further include a fourth-color emission layer, and at least one from among the first-color emission layer to the fourth-color emission layers may be a quantum dot-emission layer including the quantum dot, and the remaining emission layers may be organic emission layers including organic compounds, respectively. As such, other various suitable modifications are possible. Here, the first color through the fourth color may be colors different from each other, and for example, the first color through the fourth color may have different maximum emission wavelengths. The first color through the fourth color may be combined with each other to provide white color.

In one or more embodiments, the light-emitting device 1A may have a stacked structure in which two or more emission layers that emit light of identical or different colors contact each other or are separated from each other. At least one from among the two or more emission layers may be a quantum dot-emission layer including the quantum dot, and the other emission layer(s) may be an organic emission layer including organic compounds. As such, other various suitable modifications are possible. For example, the light-emitting device 1A may include a first-color emission layer and a second-color emission layer, and the first color and the second color may be the same color or different colors. For example, the first color and the second color may be both (e.g., simultaneously) blue color.

The emission layer may further include, in addition to the quantum dot, at least one selected from an organic compound and a semiconductor compound.

For example, the organic compound may include a host and a dopant. The host and the dopant may respectively include a host and a dopant that are commonly utilized in organic light-emitting devices.

For example, the semiconductor compound may be an organic and/or inorganic perovskite compound.

### Electron transport region in interlayer 130

The electron transport region may have: i) a single-layered structure consisting of a single layer consisting of a single material, ii) a single-layered structure consisting of a single layer including (e.g., consisting of) a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in the respective stated order.

The electron transport region may include a conductive metal oxide. Examples of the conductive metal oxide may include (e.g., may be) ZnO, TiO₂, WO₃, SnO₂, In₂O₃, Nb₂O₅, Fe₂O₃, CeO₂, SrTiO₃, Zn₂SnO₄, BaSnO₃, In₂S₃, ZnSiO, PC60BM, PC70BM, Mg-doped ZnO (ZnMgO), Al-doped ZnO (AZO), Ga-doped ZnO (GZO), In-doped ZnO (IZO), Al-doped TiO₂, Ga-doped TiO₂, In-doped TiO₂, Al-doped WO₃, Ga-doped WO₃, In-doped WO₃, Al-doped SnO₂, Ga-doped SnO₂, In-doped SnO₂, Mg-doped In₂O₃, Al-doped In₂O₃, Ga-doped In₂O₃, Mg-doped Nb₂O₅, Al-doped Nb₂O₅, Ga-doped Nb₂O₅, Mg-doped Fe₂O₃, Al-doped Fe₂O₃, Ga-doped Fe₂O₃, In-doped Fe₂O₃, Mg-doped CeO₂, Al-doped CeO₂, Ga-doped CeO₂, In-doped CeO₂, Mg-doped SrTiO₃, Al-doped SrTiO₃,Ga-doped SrTiO₃,In-doped SrTiO₃,Mg-doped Zn₂SnO₄, Al-doped Zn₂SnO₄, Ga-doped Zn₂SnO₄, In-doped Zn₂SnO₄, Mg-doped BaSnO₃, Al-doped BaSnO₃, Ga-doped BaSnO₃, In-doped BaSnO₃, Mg-doped In₂S₃, Al-doped In₂S₃, Ga-doped In₂S₃, In-doped In₂S₃, Mg-doped ZnSiO, Al-doped ZnSiO, Ga-doped ZnSiO, In-doped ZnSiO, or any combination thereof.

In an embodiment, the electron transport region (for example, the buffer layer, the hole blocking layer, the electron control layer, and/or the electron transport layer in the electron transport region) may include a metal-free compound including at least one π electron-deficient nitrogen-containing C₁-C₆₀ cyclic group.

For example, the electron transport region may include a compound represented by Formula 601:

**Formula 601** **[Ar₆₀₁]ₓₑ₁₁-[(L₆₀₁)ₓₑ₁-R₆₀₁]ₓₑ₂ₗ**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R_{1Oa},
xe11 may be 1, 2, or 3,
xe1 may be 0, 1, 2, 3, 4, or 5,
R₆₀₁ may be a C₃-C₆₀ carbocyclic group unsubstituted or substituted with at least one R_{1Oa}, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, when xe11 in Formula 601 is 2 or more, two or more of Ar₆₀₁ may be linked to each other via a single bond.

In an embodiment, Ar₆₀₁ in Formula 601 may be a substituted or unsubstituted anthracene group.

In one or more embodiments, the electron transport region may include a compound represented by Formula 601-1:

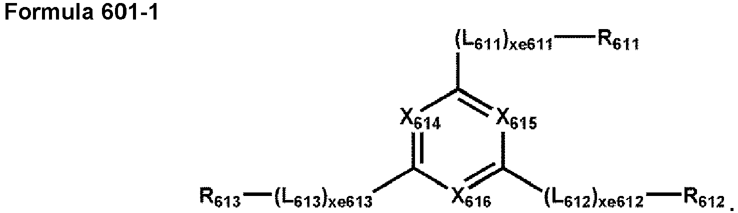

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R_{1Oa}, or a C₁-C₆₀ heterocyclic group unsubstituted or substituted with at least one R_{1Oa}.

In an embodiment, xe1 and xe611 to xe613 in Formulae 601 and 601-1 may each independently be 0, 1, or 2.

The electron transport region may include: at least one of Compounds ET1 to ET45; 2,9-dimethyl-4,7-diphenyl-1,10-phenanthroline (BCP); 4,7-diphenyl-1,10-phenanthroline (Bphen): Alq_{3;} BAIq; TAZ; NTAZ; or any combination thereof:

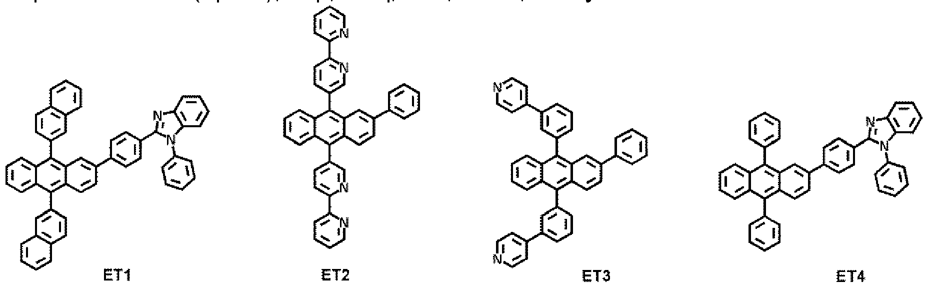

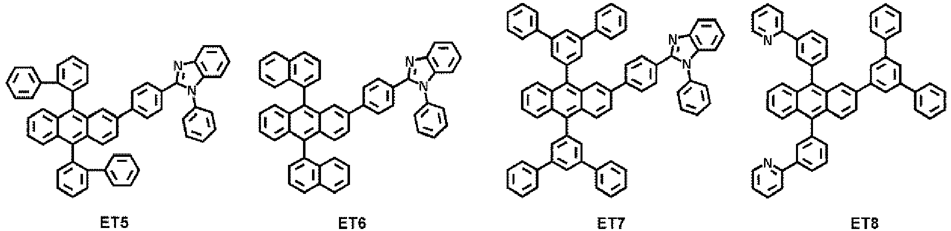

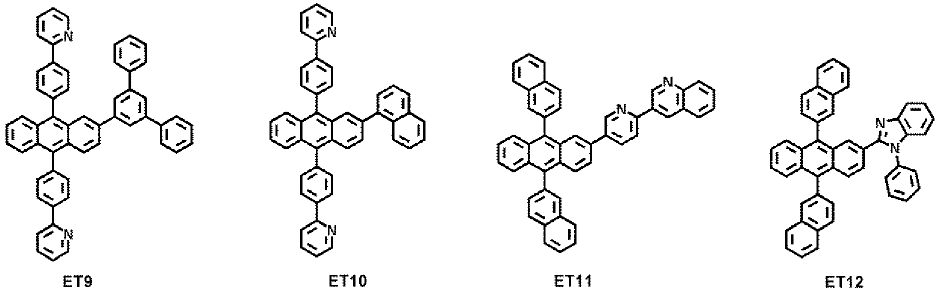

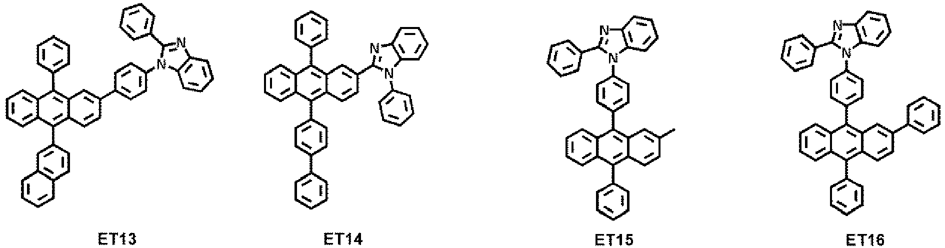

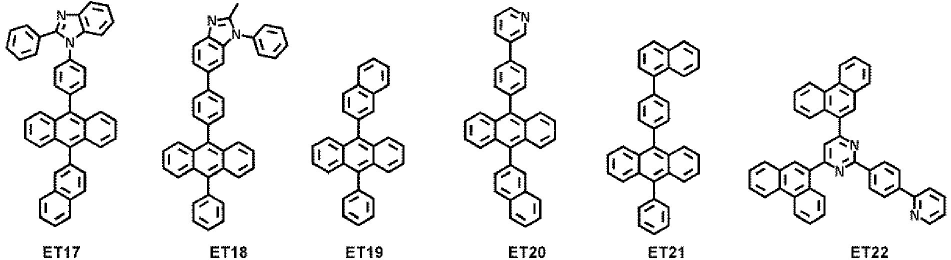

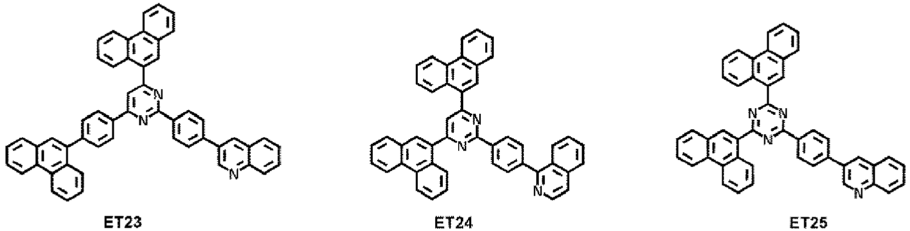

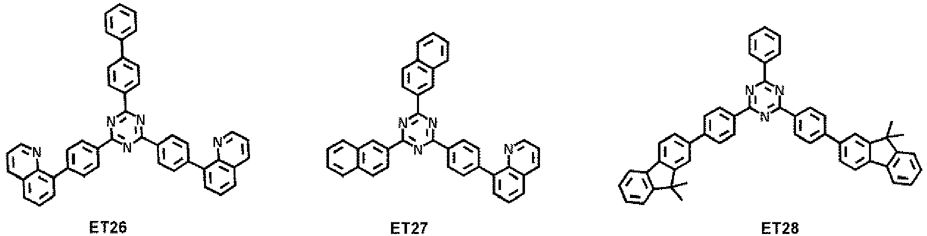

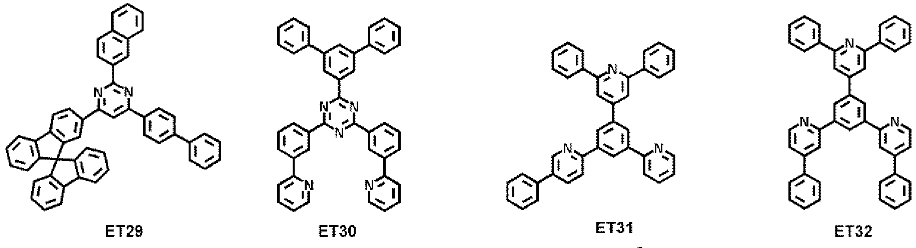

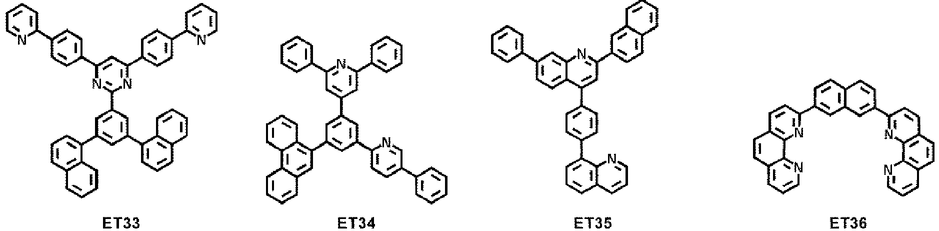

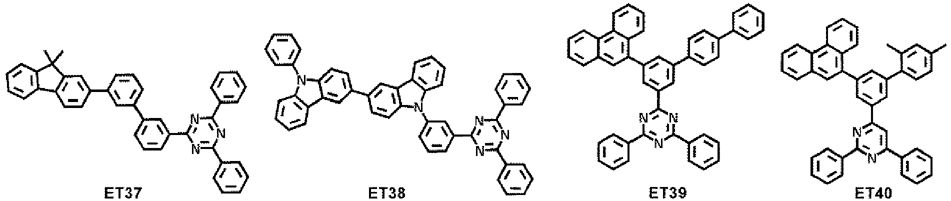

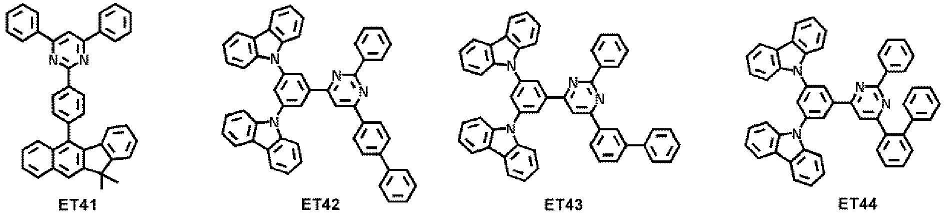

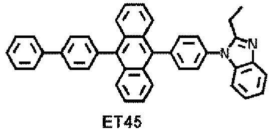

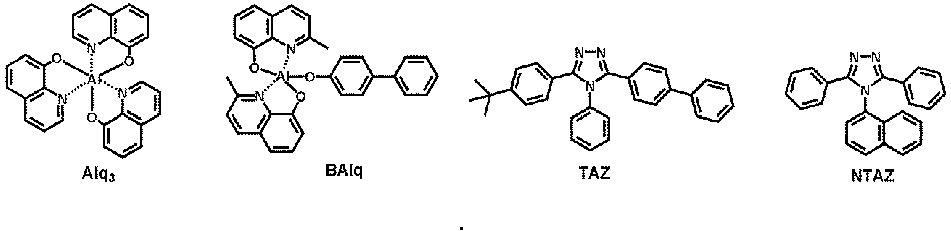

A thickness of the electron transport region may be in a range of about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, and/or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are within these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of the alkali metal complex may be a Li ion, a Na ion, a K ion, a Rb ion, or a Cs ion, and the metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or ET-D2:

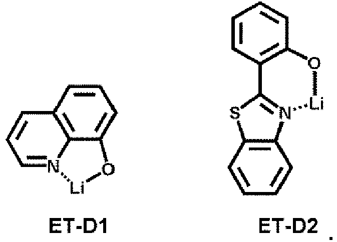

The electron transport region may include an electron injection layer that facilitates the injection of electrons from the second electrode 150. The electron injection layer may directly contact the second electrode 150.

The electron injection layer may have: i) a single-layered structure consisting of a single layer consisting of a single material, ii) a single-layered structure consisting of a single layer including (e.g., consisting of) a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be one or more oxides, halides (for example, fluorides, chlorides, bromides, iodides, etc.), and/or tellurides of the alkali metal, the alkaline earth metal, and the rare earth metal, or any combination thereof.

The alkali metal-containing compound may include: an alkali metal oxide, such as Li₂O, Cs₂O, K₂O, and/or the like; an alkali metal halide, such as LiF, NaF, CsF, KF, Lil, Nal, Csl, KI, and/or the like; or any combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In an embodiment, the rare earth metal-containing compound may include a lanthanide metal telluride. Examples of the lanthanide metal telluride may include (e.g., may be) LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one of ions of the alkali metal, the alkaline earth metal, and the rare earth metal and ii), as a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

In an embodiment, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In an embodiment, the electron injection layer may include (e.g., consist of) i) an alkali metal-containing compound (for example, an alkali metal halide), or ii) a) an alkali metal-containing compound (for example, an alkali metal halide); and b) an alkali metal, an alkaline earth metal, a rare earth metal, or any combination thereof. For example, the electron injection layer may be a KI:Yb co-deposited layer, an Rbl:Yb co-deposited layer, a LiF:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the above ranges, satisfactory electron injection characteristics may be obtained without a substantial increase in driving voltage.

### Second electrode 150

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or any combination thereof, each having a low-work function, may be utilized.

The second electrode 150 may include Li, Ag, Mg, Al, Al-Li, Ca, Mg-In, Mg-Ag, Yb, Ag-Yb, ITO, IZO, or any combination thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be arranged outside the first electrode 110 (e.g., on the side of the first electrode 110 facing oppositely away from the second electrode 150), and/or a second capping layer may be arranged outside the second electrode 150 (e.g., on the side of the second electrode 150 facing oppositely away from the first electrode 110). In some embodiments, the light-emitting device 1A may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 1A may be extracted (e.g., emitted) toward the outside through the first electrode 110, which is a semi-transmissive electrode or a transmissive electrode, and the first capping layer, or light generated in the emission layer of the interlayer 130 of the light-emitting device 1A may be extracted (e.g., emitted) toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 1A may be increased, so that the luminescence efficiency of the light-emitting device 1A may be improved.

Each of the first capping layer and the second capping layer may include a material having a refractive index of greater than or equal to 1.6 (at a wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof. In an embodiment, at least one of the first capping layer or the second capping layer may each independently include an amine group-containing compound.

In one or more embodiments, at least one of the first capping layer or the second capping layer may each independently include a compound represented by Formula 201, a compound represented by Formula 202, or any combination thereof.

In one or more embodiments, at least one of the first capping layer or the second capping layer may each independently include: at least one of Compounds HT28 to HT33; at least one of Compounds CP1 to CP6; β-NPB; or any combination thereof:

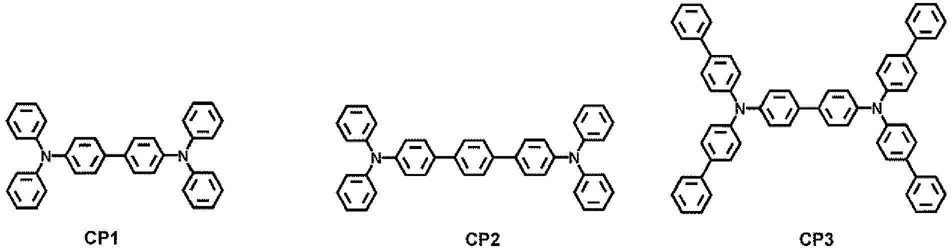

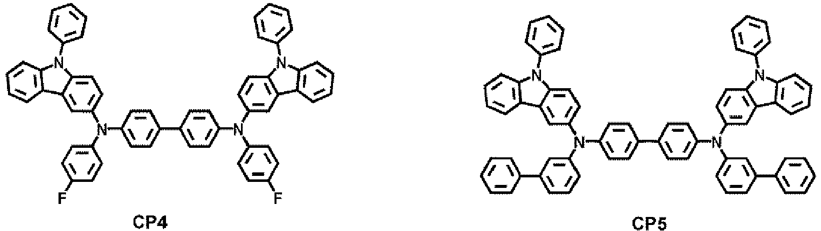

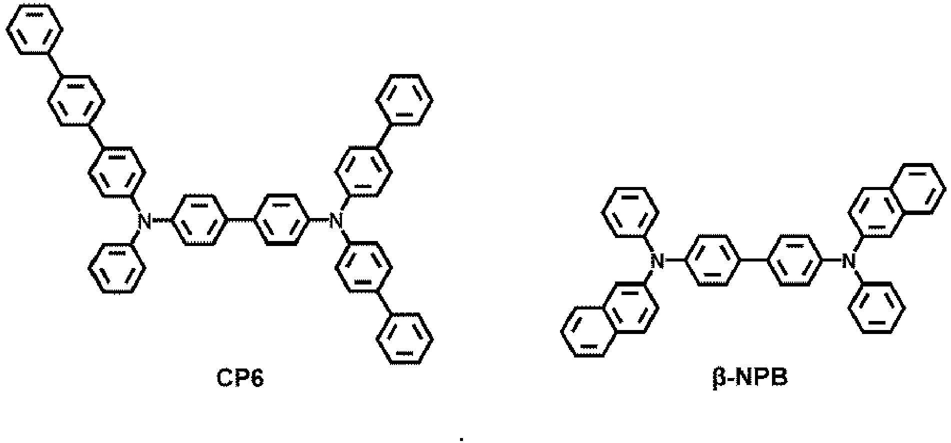

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be arranged in at least one traveling direction of light emitted from the light-emitting device. In one or more embodiments, the light emitted from the light-emitting device may be blue light or white light. Details for the light-emitting device may be the same as described herein. In an embodiment, the color conversion layer may include a quantum dot. The quantum dot may be, for example, the quantum dot as described herein.

The electronic apparatus may include a first substrate. The first substrate may include a plurality of subpixel areas, the color filter may include a plurality of color filter areas respectively corresponding to the plurality of subpixel areas, and the color conversion layer may include a plurality of color conversion areas respectively corresponding to the plurality of subpixel areas.

A pixel-defining film may be arranged among the plurality of subpixel areas to define each of the subpixel areas.

The color filter may further include a plurality of color filter areas and light-shielding patterns arranged among the plurality of color filter areas, and the color conversion layer may further include a plurality of color conversion areas and light-shielding patterns arranged among the plurality of color conversion areas.

The plurality of color filter areas (or the plurality of color conversion areas) may include a first area emitting a first color light, a second area emitting a second color light, and/or a third area emitting a third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dot(s). In an embodiment, the first area may include a red quantum dot, the second area may include a green quantum dot, and the third area may not include (e.g., may exclude) a quantum dot. The quantum dot may be the same as described herein. The first area, the second area, and/or the third area may each include a scatter (e.g., a light scatterer).

In one or more embodiments, the light-emitting device may be to emit a first light, the first area may be to absorb the first light to emit a first-first color light, the second area may be to absorb the first light to emit a second-first color light, and the third area may be to absorb the first light to emit a third-first color light. Here, the first-first color light, the second-first color light, and the third-first color light may have different maximum emission wavelengths. For example, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein the source electrode or the drain electrode may be electrically connected to the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally arranged on the sealing portion, in addition to the color filter and/or the color conversion layer, according to the usage of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device as described above, a biometric information collector.

The electronic apparatus may be applied to one or more suitable displays, light sources, lighting apparatuses, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, one or more suitable measuring instruments, meters (for example, meters for a vehicle, an aircraft, and/or a vessel), projectors, and/or the like.

### Manufacturing method

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, laser-induced thermal imaging, and/or the like.

When respective layers included in the hole transport region, the emission layer, and respective layers included in the electron transport region are formed by vacuum deposition, the vacuum deposition may be performed at a deposition temperature of about 100°C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of terms

The term "C₃-C₆₀ carbocyclic group" as used herein refers to a cyclic group consisting of only carbon atoms as ring-forming atoms and having three to sixty carbon atoms, and the term "C₁-C₆₀ heterocyclic group" as used herein refers to a cyclic group that has, in addition to one to sixty carbon atoms, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The term "cyclic group" as used herein may include both the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

For example,
the C₃-C₆₀ carbocyclic group may be i) a T1 group or ii) a condensed cyclic group in which two or more T1 groups are condensed with each other (for example, the C₃-C₆₀ carbocyclic group may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which at least two T2 groups are condensed with each other, or iii) a condensed cyclic group in which at least one T2 group and at least one T1 group are condensed with each other (for example, the C₁-C₆₀ heterocyclic group may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like.),
the π electron-rich C₃-C₆₀ cyclic group may be i) a T1 group, ii) a condensed cyclic group in which two or more T1 groups are condensed with each other, iii) a T3 group, iv) a condensed cyclic group in which two or more T3 groups are condensed with each other, or v) a condensed cyclic group in which at least one T3 group and at least one T1 group are condensed with each other (for example, the π electron-rich C₃-C₆₀ cyclic group may be the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like.),
the π electron-deficient nitrogen-containing C₁-C₆₀ cyclic group may be i) a T4 group, ii) a condensed cyclic group in which at least two T4 groups are condensed with each other, iii) a condensed cyclic group in which at least one T4 group and at least one T1 group are condensed with each other, iv) a condensed cyclic group in which at least one T4 group and at least one T3 group are condensed with each other, or v) a condensed cyclic group in which at least one T4 group, at least one T1 group, and at least one T3 group are condensed with one another (for example, the π electron-deficient nitrogen-containing C₁-C₆₀ cyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group," "the C₁-C₆₀ heterocyclic group," "the π electron-rich C₃-C₆₀ cyclic group," or "the π electron-deficient nitrogen-containing C₁-C₆₀ cyclic group" as used herein each refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, and/or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group may include (e.g., may be) a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the divalent C₁-C₆₀ heterocyclic group may include (e.g., may be) a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof may include (e.g., may be) a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having substantially the same structure as the C₁-C₆₀ alkyl group.

The term "C₂-C₆₀ alkenyl group" as used herein refers to a monovalent hydrocarbon group having at least one carbon-carbon double bond in the middle and/or at a terminal end (e.g., the terminus) of the C₂-C₆₆ alkyl group, and examples thereof may include (e.g., may be) an ethenyl group, a propenyl group, a butenyl group, and/or the like. The term "C₂-C₆₀ alkenylene group" as used herein refers to a divalent group having substantially the same structure as the C₂-C₆₀ alkenyl group.

The term "C₂-C₆₀ alkynyl group" as used herein refers to a monovalent hydrocarbon group having at least one carbon-carbon triple bond in the middle and/or at a terminal end (e.g., the terminus) of the C₂-C₆₀ alkyl group, and examples thereof may include (e.g., may be) an ethynyl group, a propynyl group, and/or the like. The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof may include (e.g., may be) a methoxy group, an ethoxy group, an isopropyloxy group, and/or the like.

The term "C₃-C₁₀ cycloalkyl group" as used herein refers to a monovalent saturated hydrocarbon cyclic group having 3 to 10 carbon atoms, and examples thereof may include (e.g., may be) a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent saturated monocyclic group that includes, in addition to 1 to 10 carbon atoms, at least one heteroatom, as ring-forming atoms, and examples thereof may include (e.g., may be) a 1,2,3,4-oxatriazolidinyl group, a tetrahydrofuranyl group, a tetrahydrothiophenyl group, and/or the like. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and examples thereof may include (e.g., may be) a cyclopentenyl group, a cyclohexenyl group, a cycloheptenyl group, and/or the like. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent cyclic group that includes, in addition to 1 to 10 carbon atoms, at least one heteroatom, as ring-forming atoms, and having at least one carbon-carbon double bond in the cyclic structure thereof. Examples of the C₁-C₁₀ heterocycloalkenyl group may include (e.g., may be) a 4,5-dihydro-1 ,2,3,4-oxatriazolyl group, a 2,3-dihydrofuranyl group, a 2,3-dihydrothiophenyl group, and/or the like. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group may include (e.g., may be) a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, a fluorenyl group, and/or the like. When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system that includes, in addition to 1 to 60 carbon atoms, at least one heteroatom, as ring-forming atoms. The term "C₁-C₆₀ heteroarylene group" as used herein refers to a divalent group having a heterocyclic aromatic system that includes, in addition to 1 to 60 carbon atoms, at least one heteroatom, as ring-forming atoms. Examples of the C₁-C₆₀ heteroaryl group may include (e.g., may be) a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a carbazolyl group, a dibenzofuranyl group, a dibenzothiofuranyl group, and a naphthyridinyl group. When the C₁-C₆₀ heteroaryl group and the C₁-C₆₀ heteroarylene group each include two or more rings, the rings may be condensed with each other.

The term "monovalent non-aromatic condensed polycyclic group" as used herein refers to a monovalent group having two or more rings condensed to each other, only carbon atoms (for example, having 8 to 60 carbon atoms) as ring-forming atoms, and no aromaticity in its entire molecular structure (e.g., is not aromatic when considered as a whole). Examples of the monovalent non-aromatic condensed polycyclic group may include (e.g., may be) an indenyl group, a fluorenyl group, a spiro-bifluorenyl group, a benzofluorenyl group, an indenophenanthrenyl group, an indeno anthracenyl group, an adamantyl group, and/or the like. The term "divalent non-aromatic condensed polycyclic group" as used herein refers to a divalent group having substantially the same structure as the monovalent non-aromatic condensed polycyclic group described above.

The term "monovalent non-aromatic condensed heteropolycyclic group" as used herein refers to a monovalent group having two or more rings condensed to each other, in addition to carbon atoms (for example, having 1 to 60 carbon atoms), at least one heteroatom, as ring-forming atoms, and having non-aromaticity in its entire molecular structure (e.g., is not aromatic when considered as a whole). Examples of the monovalent non-aromatic condensed heteropolycyclic group may include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, an azaadamantyl group, and/or the like. The term "divalent non-aromatic condensed heteropolycyclic group" as used herein refers to a divalent group having substantially the same structure as the monovalent non-aromatic condensed heteropolycyclic group described above.

The term "C₆-C₆₀ aryloxy group" as used herein refers to a monovalent group represented by -OA₁₀₂ (wherein A₁₀₂ is the C₆-C₆₀ aryl group), and the term "C₆-C₆₀ arylthio group" as used herein refers to a monovalent group represented by -SA₁₀₃ (wherein A₁₀₃ is the C₆-C₆₀ aryl group).

The term "C₇₋C₆₀ aryl alkyl group" as used herein refers to a monovalent group represented by -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to a monovalent group represented by -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

In the present specification, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇₋C₆₀ aryl alkyl group; or a C₂-C₆₀ heteroaryl alkyl group.

The term "heteroatom" as used herein refers to any atom other than a carbon atom. Examples of the heteroatom may include (e.g., may be) O, S, N, P, Si, B, Ge, Se, or any combination thereof.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group." In other words, the "terphenyl group" is a substituted phenyl group having, as a substituent, a C₆-C₆₀ aryl group substituted with a C₆-C₆₀ aryl group.
* and *' as used herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was utilized instead of A" used in describing Synthesis Examples refers to that an identical molar equivalent of B was utilized in place of A.

### Examples

### Comparative Example 1. Preparation of InP core

1 mL of indium oleate (In(OA)₃) and 0.25 mL of zinc oleate (Zn(OA)₂) were mixed with 10 mL of 1-octadecene, and moisture and oxygen in a reaction vessel were removed at 120°C for 1 hour. After the removal, the temperature in the reaction vessel was cooled to room temperature. Then, in a nitrogen atmosphere, 0.1 mmol of tris(trimethylsilyl)phosphine ((TMS)₃P) was injected. After the injection, the mixed solution was maintained at 300°C for 10 minutes. Then, the temperature was cooled to room temperature, and purification was performed by utilizing hexane and ethanol.

### Example 1. Preparation of surface-etched InP core

The InP core prepared according to Comparative Example 1 was re-dispersed in 1-octadecene. AlCl₃ was injected thereto, and the mixed solution was maintained at 250 °C for 30 minutes, so as to prepare InP core with an etched surface.

### Evaluation Example 1

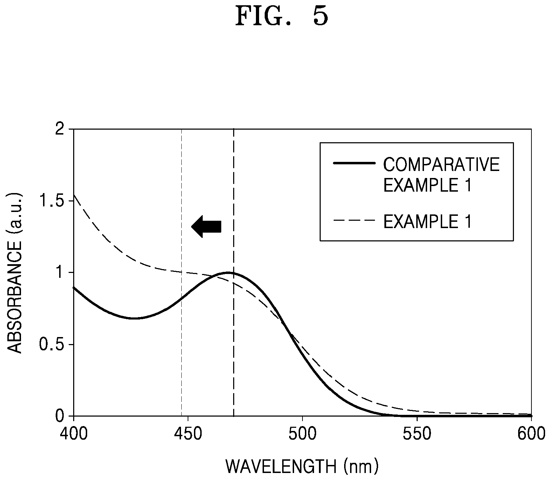

For each of the InP cores of Comparative Example 1 and Example 1, first exciton peaks were measured, and results are shown in FIG. 5.

Referring to FIG. 5, it was confirmed that the first exciton peak for the InP core of Example 1 was shifted to a shorter wavelength region by about 20 nm compared to the InP core of Comparative Example 1.

### Example 2. Preparation of quantum dot(s) (each) including surface-etched InP core

The InP core prepared according to Comparative Example 1 was re-dispersed in 1-octadecene. GaCl₃ was injected thereto, and the mixed solution was maintained at 250 °C for 30 minutes, so as to prepare InP core with an etched surface.

After raising the temperature to 220 °C, a solution containing the prepared InP core was injected to a mixed solution containing 5 mL of Zn(OA)₂, 0.1 mL of trioctylphosphine selenide (TOPSe), and 1.9 mL of trioctylphosphine sulfide (TOPS). Afterwards, by heating at 300 °C and allowing a reaction for 10 minutes, quantum dot(s) were prepared.

### Example 3.

Quantum dot(s) were prepared in the same manner as in Example 2, except that AlCl₃ was injected instead of GaCl₃ and at 280 °C instead of 250 °C.

### Comparative Example 2. Preparation of InGaP/ZnSeS quantum dot

Quantum dots were prepared in substantially the same manner as in Example 2, except that Gal₃ was injected instead of GaCl₃ and at 280 °C instead of instead of 250 °C.

### Evaluation Example 2

For each of the quantum dots of Examples 2 and 3, and Comparative Example 2, inductively coupled plasma (ICP) analysis was performed, and results are shown in Table 1.

**Table 1**

| | P | Zn | Ga or Al | In | Se | S |
|---|---|---|---|---|---|---|
| Comparative Example 2 | 1.0 | 14.7 | 0.2 | 0.8 | 3.1 | 8.8 |
| Example 2 | 1.0 | 27.7 | 0.0 | 1.3 | 5.9 | 16.8 |
| Example 3 | 1.0 | 25.8 | 0.0 | 1.2 | 5.7 | 15.2 |

Referring to Table 1, it was confirmed that the quantum dots of Examples 2 and 3 did not include Ga or Al as a surface-etching material.

According to the one or more embodiments, a quantum dot having a short emission wavelength (for example, blue light) and a method of effectively preparing the quantum dot may be provided.

The electronic apparatus, the display device, and/or any other relevant devices or components according to embodiments of the present invention described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A quantum dot (100) comprising:
a core (10); and
a shell (20) around at least a portion of the core (10),
wherein the core (10) comprises a first semiconductor compound (11) comprising or consisting of indium (In) and phosphorus (P), and
in the first semiconductor compound (11), a ratio between a number of moles (mol) of In and a number of moles (mol) of P (M^{In}/M^{P}) is greater than 1, wherein a maximum emission wavelength of the quantum dot (100) is in a range of 430 nm to 470 nm.

2. The quantum dot of claim 1, wherein the core (10) further comprises a second semiconductor compound (12) comprising a first element and P, and
a bond-dissociation energy between the first element and P is greater than a bond-dissociation energy between In and P.

3. The quantum dot of claim 2, wherein the first element comprises Ga, Al, Sb, As, Bi, or any combination thereof.

4. The quantum dot of claim 2, wherein the second semiconductor compound (12) comprises GaP, AIP, SbP, As₃P, BiP, or any combination thereof.

5. The quantum dot of claim 1, wherein the shell (20) comprises ZnS, ZnSe, ZnTe, ZnO, ZnSeS, ZnTeS, GaAs, GaP, GaN, GaO, GaSb, HgS, HgSe, HgTe, InAs, InP, InS, InGaP, InSb, InZnP, InZnS, InGaP, InGaN, AlAs, AIP, AlSb, PbS, TiO, SrSe, or any combination thereof.

6. A method of preparing a quantum dot, the method comprising:
preparing a core (10) comprising a first semiconductor compound (11); and
preparing a shell (20) around at least a portion of the core (20),
wherein the preparing of the core (20) comprises:
preparing a precursor (11a) of the first semiconductor compound (11) comprising or consisting of indium (In) and phosphorus (P);
preparing a mixture comprising the precursor (11a) of the first semiconductor compound (11) and a surface-etching material; and
preparing the first semiconductor compound (11) utilizing the mixture,
wherein, in the first semiconductor compound (11), a ratio between a number of moles (mol) of In and a number of moles (mol) of P (M^{In}/M^{P}) is greater than 1,
wherein the surface-etching material comprises a first element, and
a bond-dissociation energy between the first element and P is greater than a binding energy between In and P.

7. The method of claim 6, wherein the first element comprises Ga, Al, Sb, As, Bi, or any combination thereof.

8. The method of claim 6 or 7, wherein the surface-etching material comprises a second element, and
the second element comprises F or Cl.

9. The method of claim 6, wherein the surface-etching material comprises GaF₃, AlF₃, SbF₃, AsF, BiF₃, GaCl₃, AlCl₃, SbCl₃, AsCI, BiCl₃, or any combination thereof.

10. The method of claim 6, wherein the preparing of the core (20) further comprises preparing a second semiconductor compound (12) utilizing the mixture,
wherein the second semiconductor compound (12) comprises a first element and P, and
a bond-dissociation energy between the first element and P is greater than a bond-dissociation energy between In and P.

11. An electronic apparatus (200a) comprising the quantum dot (100) of claim 1.

12. The electronic apparatus (200a) of claim 11, further comprising:
a light source (220); and
a color conversion member (230) arranged in a path of light emitted from the light source (220),
wherein the quantum dot (100) is comprised in the color conversion member (230).

13. The electronic apparatus (200a) of claim 11, further comprising:
a light-emitting device (1a) comprising:
a first electrode (110);
a second electrode facing the first electrode (110); and
an emission layer between the first electrode (110) and the second electrode,
wherein the quantum dot (100) is comprised in the light-emitting device (1a).

## Patentansprüche

1. Quantenpunkt (100), umfassend:
einen Kern (10); und
eine Hülle (20) um zumindest einen Teil des Kerns (10),
wobei der Kern (10) eine erste Halbleiterverbindung (11), umfassend oder bestehend aus Indium (In) und Phosphor (P), umfasst, und
in der ersten Halbleiterverbindung (11) ein Verhältnis zwischen einer Molzahl (mol) von In und einer Molzahl (mol) von P (M^{In}/M^{P}) größer als 1 ist, wobei eine Wellenlänge maximaler Emission des Quantenpunkts (100) in einem Bereich von 430 nm bis 470 nm liegt.

2. Quantenpunkt nach Anspruch 1, wobei der Kern (10) weiterhin eine zweite Halbleiterverbindung (12), umfassend ein erstes Element und P, umfasst, und
eine Bindungsdissoziationsenergie zwischen dem ersten Element und P größer als eine Bindungsdissoziationsenergie zwischen In und P ist.

3. Quantenpunkt nach Anspruch 2, wobei das erste Element Ga, Al, Sb, As, Bi, oder eine Kombination davon umfasst.

4. Quantenpunkt nach Anspruch 2, wobei die zweite Halbleiterverbindung (12) GaP, AIP, SbP, As₃P, BiP, oder eine Kombination davon umfasst.

5. Quantenpunkt nach Anspruch 1, wobei die Hülle (20) ZnS, ZnSe, ZnTe, ZnO, ZnSeS, ZnTeS, GaAs, GaP, GaN, GaO, GaSb, HgS, HgSe, HgTe, InAs, InP, InS, InGaP, InSb, InZnP, InZnS, InGaP, InGaN, AlAs, AlP, AlSb, PbS, TiO, SrSe, oder eine Kombination davon umfasst.

6. Verfahren zur Herstellung eines Quantenpunkts, umfassend:
Herstellen eines Kerns (10), umfassend eine erste Halbleiterverbindung (11); und
Herstellen einer Hülle (20) um zumindest einen Teil des Kerns (20),
wobei das Herstellen des Kerns (20) umfasst:
Herstellen einer Vorstufe (11a) der ersten Halbleiterverbindung (11), umfassend oder bestehend aus Indium (In) und Phosphor (P);
Herstellen eines Gemisches, umfassend die Vorstufe (11a) der ersten Halbleiterverbindung (11) und ein Oberflächenätzmaterial; und
Herstellen der ersten Halbleiterverbindung (11) unter Verwendung des Gemisches,
wobei in der ersten Halbleiterverbindung (11) ein Verhältnis zwischen einer Molzahl (mol) von In und einer Molzahl (mol) von P (M^{In}/M^{P}) größer als 1 ist,
wobei das Oberflächenätzmaterial ein erstes Element umfasst, und
eine Bindungsdissoziationsenergie zwischen dem ersten Element und P größer als eine Bindungsdissoziationsenergie zwischen In und P ist.

7. Verfahren nach Anspruch 6, wobei das erste Element Ga, Al, Sb, As, Bi, oder eine Kombination davon umfasst.

8. Verfahren nach Anspruch 6 oder 7, wobei das Oberflächenätzmaterial ein zweites Element umfasst, und
das zweite Element F oder CI umfasst.

9. Verfahren nach Anspruch 6, wobei das Oberflächenätzmaterial GaF₃, AlF₃, SbF₃, AsF, BiF₃, GaCl₃, AlCl₃, SbCl₃, AsCl, BiCl₃, oder eine Kombination davon umfasst.

10. Verfahren nach Anspruch 6, wobei das Herstellen des Kerns (20) weiterhin das Herstellen einer zweiten Halbleiterverbindung (12) unter Verwendung des Gemisches umfasst,
wobei die zweite Halbleiterverbindung (12) ein erstes Element und P umfasst, und
eine Bindungsdissoziationsenergie zwischen dem ersten Element und P größer als eine Bindungsdissoziationsenergie zwischen In und P ist.

11. Elektronische Einrichtung (200a), umfassend den Quantenpunkt (100) nach Anspruch 1.

12. Elektronische Einrichtung (200a) nach Anspruch 11, weiterhin umfassend:
eine Lichtquelle (220); und
ein Farbkonversionselement (230), angeordnet in einer Bahn von aus der Lichtquelle (220) emittiertem Licht,
wobei der Quantenpunkt (100) in dem Farbkonversionselement (230) umfasst ist.

13. Elektronische Einrichtung (200a) nach Anspruch 11, weiterhin umfassend:
eine lichtemittierende Vorrichtung (1a), umfassend:
eine erste Elektrode (110);
eine zweite Elektrode, die der ersten Elektrode (110) gegenüberliegt; und
eine Emissionsschicht zwischen der ersten Elektrode (110) und der zweiten Elektrode,
wobei der Quantenpunkt (100) in der lichtemittierenden Vorrichtung (1a) umfasst ist.

## Revendications

1. Outil de biopsie endoluminale (1), ledit outil (1) comprenant un tube externe (2), et un instrument disposé dans le tube externe (2), dans lequel le tube externe (2) et l'instrument sont mobiles l'un par rapport à l'autre pour effectuer la biopsie, dans lequel l'instrument est un tube interne (3) s'adaptant de manière mobile à l'intérieur du tube externe (2), dans lequel le tube interne (3) présente une paroi (3') qui est munie d'une découpe (6),
**caractérisé en ce que** le tube externe (2) est muni d'une languette (4) s'étendant depuis une partie distale (5) du tube externe (2), et en outre **caractérisé en ce que** la découpe (6) dans la paroi (3') du tube interne (3) est refermable avec la languette (4).

2. Outil de biopsie endoluminale (1) selon la revendication 1, **caractérisé en ce que** la découpe (6) est refermable par un mouvement d'avance en translation du tube externe (2) par rapport au tube interne (3).

3. Outil de biopsie endoluminale (1) selon la revendication 1 ou 2, **caractérisé en ce que** la languette (4) présente un bord de coupe avant.

4. Outil de biopsie endoluminale (1) selon l'une quelconque des revendications 1 à 3, **caractérisé en ce que** la découpe (6) est refermable par un mouvement de rotation du tube externe (2) et du tube interne (3) l'un par rapport à l'autre.

5. Outil de biopsie endoluminale (1) selon l'une quelconque des revendications 1 à 4, **caractérisé en ce que** la languette (4) présente des bords latéraux de coupe (4').

6. Outil de biopsie endoluminale selon l'une quelconque des revendications 1 à 5, **caractérisé en ce que** le tube externe (2) et le tube interne (3) sont mobiles en translation et/ou en rotation l'un par rapport à l'autre, et le tube interne (3) présente une partie distale biseautée (7), et la languette (4) est munie d'une position préférentielle dans laquelle la languette (4) referme la partie distale biseautée (7) du tube interne (3) lorsque le tube interne (3) est placé dans une position partiellement rétractée par rapport au tube externe (2).

7. Outil de biopsie endoluminale selon la revendication 6, **caractérisé en ce que** la languette (4) présente une position préférentielle dans laquelle la languette (4) fait saillie de manière oblique vers le tube interne (3) lorsque la languette (4) est déchargée.

8. Outil de biopsie endoluminale selon l'une quelconque des revendications 1 à 7, **caractérisé en ce que** la languette (4) est montée de manière élastique dans une position oblique sur la partie distale (5) du tube externe (2).

9. Outil de biopsie endoluminale selon l'une quelconque des revendications 1 à 8, **caractérisé en ce que** la découpe (6) est refermable avec la languette (4) lorsque le tube interne (3) s'étend au-delà de la partie distale (5) du tube externe (2), dans lequel la languette (4) est chargée par et vient en prise avec le tube interne (3).

10. Outil de biopsie endoluminale selon la revendication 9, **caractérisé en ce que** la languette (4) est chargée par le tube interne (3), la languette (4) adopte une orientation sensiblement droite par rapport au tube externe (2).

11. Outil de biopsie endoluminale selon l'une quelconque des revendications 1 à 10, **caractérisé en ce que** le tube externe (2) est pourvu d'une autre découpe (8), présentant des dimensions qui sont sensiblement identiques aux dimensions de la découpe (6) dans le tube interne (3).

12. Outil de biopsie endoluminale selon la revendication 11, **caractérisé en ce que** l'autre découpe (8) présente des bords latéraux de coupe (8').

13. Outil de biopsie endoluminale selon la revendication 11 ou 12, **caractérisé en ce que** l'autre découpe (8) s'étend à travers et est ouverte au niveau de la partie distale (5) du tube externe (2).
